(19) Europäisches Patentamt / European Patent Office / Office européen des brevets

(11) **EP 2 613 181 B1**

(12) **FASCICULE DE BREVET EUROPEEN**

(45) Date de publication et mention
de la délivrance du brevet:
**31.08.2022 Bulletin 2022/35**

(21) Numéro de dépôt: **12197617.9**

(22) Date de dépôt: **17.12.2012**

(51) Classification Internationale des Brevets (IPC):
**G02B 5/18** *(2006.01)*       **G02B 5/20** *(2006.01)*
**H01L 27/146** *(2006.01)*    **G01J 5/0875** *(2022.01)*
**G01J 5/0802** *(2022.01)*    **G01J 5/0803** *(2022.01)*

(52) Classification Coopérative des Brevets (CPC):
(C-Sets disponibles)
**G01J 5/0803; G01J 5/0802; G01J 5/0875;
G02B 5/1814; G02B 5/203; G02B 5/208;
H01L 27/14618; H01L 27/14625; H01L 27/14649;**
H01L 2924/0002                           (Cont.)

(54) **Détecteur infrarouge comportant un boîtier intégrant au moins un réseau de diffraction**

INFRAROTDETEKTOR MIT GEHÄUSE MIT MINDESTENS EINEM INTEGRIERTEN BEUGUNGSGITTER

INFRARED DETECTOR COMPRISING HOUSING INTEGRATING AT LEAST ONE DIFFRACTION GRATING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **05.01.2012 FR 1250106**

(43) Date de publication de la demande:
**10.07.2013 Bulletin 2013/28**

(73) Titulaire: **LYNRED
91120 Palaiseau (FR)**

(72) Inventeur: **Favier, Jérôme
38380 SAINT LAURENT DU PONT (FR)**

(74) Mandataire: **Cabinet Laurent & Charras
Le Contemporain
50 Chemin de la Bruyère
69574 Dardilly Cedex (FR)**

(56) Documents cités:
EP-A1- 1 767 964        EP-A2- 1 104 181
WO-A2-02/054499       JP-A- 59 057 205
JP-A- 2000 284 115      JP-A- 2004 119 117
US-A- 5 119 231          US-A1- 2004 240 064
US-A1- 2006 163 453    US-A1- 2009 080 075
US-A1- 2011 156 987

(52) Classification Coopérative des Brevets (CPC):
(Cont.)

C-Sets
H01L 2924/0002, H01L 2924/00

## Description

### DOMAINE DE L'INVENTION

L'invention a trait au domaine de la détection ou de l'imagerie infrarouge, et notamment la détection micro-bolométrique. Plus particulièrement, l'invention a trait aux techniques permettant d'ajuster les propriétés spectrales des boitiers contenant les éléments sensibles de détection.

### ETAT DE LA TECHNIQUE

Des détecteurs bien connus de l'état de la technique destinés à l'imagerie ou thermographie infrarouge comprennent une rétine sensible, placée dans le plan focal d'une optique et intégrée dans un boîtier habituellement hermétique, qui protège la rétine et maintient celle-ci dans une ambiance sous très basse pression habituellement nécessaire à son bon fonctionnement. La rétine est constituée d'un assemblage bidimensionnel d'éléments unitaires sensibles, ou « pixels », formés en surface d'une puce électronique dite « circuit de lecture » (ROIC) comportant une circuiterie d'adressage et de formation du signal de chaque pixel. L'ensemble de ces signaux forme ainsi l'image électrique en relation avec une scène thermique, observée au moyen d'une optique adaptée qui focalise l'image thermique au niveau de la rétine sensible.

La paroi du boîtier, placée sur le trajet optique entre l'optique et la rétine, usuellement dénommée « fenêtre », est constituée d'un substrat plan essentiellement transparent au rayonnement d'intérêt, à savoir entre 8 $\mu$m et 14 $\mu$m pour la détection infrarouge adaptée au cas le plus courant de l'observation de scènes au voisinage de 300K.

Afin d'optimiser d'une part la transmission dans cette bande, et d'autre part limiter la transmission en dehors de cette bande, et plus particulièrement pour des longueurs d'onde inférieures à 8 $\mu$m, des filtres optiques sont usuellement appliqués sur les deux faces de la fenêtre.

Une transmission aussi faible que possible entre 2 $\mu$m et 8 $\mu$m est en effet recherchée pour éviter que le détecteur ne réponde dans le spectre où la sensibilité dépend de la distance d'observation entre l'objet émissif et le plan focal, et qu'en conséquence l'intensité infrarouge détectée ne soit dépendante de la transparence limitée de l'atmosphère sur cette partie du spectre. En outre, limiter la transmission entre 2 $\mu$m et 8 $\mu$m permet de ne pas exposer les éléments sensibles de la rétine aux rayonnements énergétiques des sources très chaudes qui peuvent apparaitre dans le champ observé et occasionner une détérioration temporaire, voire définitive, des éléments sensibles.

Usuellement, et de manière pratique, les filtres optiques réalisés sur les faces de la fenêtre sont constitués d'empilements interférentiels formés de nombreuses couches minces d'épaisseur prédéterminée, chacune essentiellement transparente entre 2 et 20 $\mu$m, avec une alternance de couches de bas indice de réfraction, usuellement en sulfure de zinc, et de couches de haut indice de réfraction, usuellement en germanium. Il est ainsi possible et connu de contrôler et d'optimiser dans une certaine mesure le spectre de transmission de l'interface air-substrat de la fenêtre sur une première face, et sur la face opposée, d'optimiser la transmission substrat - air (ou vide).

La qualité d'un filtre est par ailleurs déterminée par les caractéristiques des défauts, notamment les éclats, les rayures, les inclusions et autres défauts de structure qu'il contient. En effet, ces défauts et imperfections sont susceptibles de perturber les images formées par le détecteur, et ce d'autant plus que les filtres sont proches du plan focal, et donc des éléments sensibles de détection. On notera ainsi qu'à ce titre, les défauts du filtre réalisé sur la surface de la fenêtre la plus proche du plan focal perturbe plus fortement les images formées par le détecteur que les défauts du filtre réalisé sur l'autre surface de la fenêtre.

Or, les détecteurs modernes tendent précisément à présenter des dimensions de plus en plus réduites, en particulier en épaisseur, c'est-à-dire selon l'axe optique, notamment pour s'accommoder d'optiques à très faible distance focale. Il convient donc de prévoir des filtres dont les défauts sont de dimension de plus en plus réduite, au fur et à mesure de la miniaturisation des détecteurs, et présentant une densité surfacique de défauts également de plus en plus réduite.

Toutefois, ces spécifications de plus en plus sévères deviennent un problème en termes économiques, car le coût de ces filtres optiques croît rapidement du fait des précautions particulières de procédé qui doivent être mises en œuvre ou/et des pertes de rendement associées. Les performances obtenues ou encore les coûts induits par cette approche ne sont pas encore adaptés au besoin relatif au domaine des composants de détection infrarouge actuels.

La réduction de l'épaisseur des filtres optiques est une voie usuellement explorée pour améliorer leur qualité. En effet, le nombre et la taille des défauts structuraux augmente avec l'épaisseur des filtres. Ainsi, la réduction de leur épaisseur conduit à une diminution sensible de la taille et du nombre de défauts, de même que le coût de revient du traitement optique multicouche. Toutefois, la réduction de l'épaisseur totale s'accompagne typiquement d'une réduction du nombre de couches mises en œuvre, ce qui conduit nécessairement à un relâchement des spécifications de transmission spectrale. Cette approche conduit donc à accepter une dégradation en termes de performances des filtres et de susceptibilité du détecteur aux sources très chaudes, en échange d'un coût plus faible et de défauts réduits en taille et en nombre, c'est-à-dire une meilleure défectivité.

Une autre voie de l'état de la technique pour l'amélioration de la défectivité consiste en la mise en œuvre d'un réseau bidimensionnel micro-structuré par gravure directe de la ou des surfaces de la fenêtre. Cette technique est décrite par exemple dans les documents WO 02/054499 et US 2009/080075. Cette technique est toutefois très marginalement mise en œuvre, du fait en particulier du coût des techniques et instruments nécessaires associés. En outre, la simplicité de ces structures n'autorise pas la définition de spectres de transmission tels que recherchés pour la détection infrarouge bolométrique. En effet, il est obtenu de cette manière l'équivalent d'une ou au mieux de deux couches interférentielles, on n'obtient ainsi qu'une fonction d'antireflet, ce qui limite sévèrement le potentiel d'optimisation global du filtre obtenu.

Il reste donc nécessaire de former une structure habituelle sous forme de traitement multicouche sur l'autre face de la fenêtre pour obtenir une transmission faible entre 2 et 8 $\mu$m, avec les inconvénients précédemment cités.

## EXPOSE DE L'INVENTION

Le but de la présente invention est de résoudre le problème exposé ci-dessus en proposant un détecteur bolométrique infrarouge dont la fenêtre assure un spectre de filtrage adapté à la détection infrarouge bolométrique, de très faible défectivité et réalisable à faible coût au moyen de techniques usuelles de fabrication collective à grande échelle.

A cet effet, l'invention a pour objet un détecteur infrarouge comportant les caractéristiques récitées dans la revendication 1.

En d'autres termes, l'invention réside dans la combinaison d'un premier filtre, notamment un filtre multicouche interférentiel, formé sur l'une des faces (dite première face) de la fenêtre, et d'un filtre utilisant les propriétés diffractives de réseaux obtenus par exemple par texturation superficielle sur l'autre face (dite seconde face) de ladite fenêtre.

Selon cette combinaison, le premier filtre atténue la transmission de la fenêtre sur une première gamme de longueurs d'onde, par exemple dans la gamme comprise entre 2 et 5 $\mu$m, et la texturation en réseau atténue la transmission de la fenêtre sur une seconde gamme de longueurs d'onde, dans la gamme comprise entre 5 et 8 $\mu$m par exemple. Ces fonctions particulières sont obtenues simultanément à l'obtention d'une transmission élevée du rayonnement au travers des deux faces de la fenêtre dans la gamme de longueurs d'onde d'intérêt comprise entre 8 et 14 $\mu$m.

Le remplacement d'un filtre multicouche interférentiel par un filtre diffractif selon l'invention, sur l'une des faces au moins d'une fenêtre d'un détecteur infrarouge, permet d'améliorer très sensiblement la maîtrise industrielle de la qualité de l'ensemble, c'est à dire la densité et la taille des défauts structuraux qui perturbent la propagation du front d'onde incident porteur de l'information utile. Il en résulte une grande facilité de fabrication de composants de dimensions réduites, malgré des spécifications très sévères sur la qualité de la fenêtre.

En effet, les filtres diffractifs sont réalisables à l'aide de techniques usuelles de fabrication, et ce de manière reproductible et précise. Notamment, l'usage de substrats minéraux transparents aux rayons infrarouges, tels que le silicium ou le germanium, permet d'exploiter des technologies issues de la microélectronique, dont plus particulièrement la réalisation d'un masque du réseau défini par photolithographie, et la formation des motifs en relief ou en creux du réseau par des méthodes de gravure sèche en environnement propre. Ces technologies permettent d'obtenir une reproductibilité et une qualité en termes de défauts bien supérieures à ce qui est typiquement réalisé par dépôt de filtres multicouches interférentiels selon les techniques du domaine, généralement par évaporation.

De plus, la reproductibilité des méthodes de fabrication utilisées permet typiquement d'atteindre des rendements de fabrication plus élevés que ceux obtenus selon les techniques traditionnelles de dépôt de filtres multicouches interférentiels.

Par ailleurs l'utilisation de techniques de fabrication rapides et largement collectives et automatisées, difficiles, voir impossibles à utiliser pour les filtres multicouches interférentiels, conduit à des coûts de fabrication compatibles avec le besoin de modération de ces derniers.

La fabrication collective de fenêtres optiques avec des traitements multicouches pour l'infrarouge, sur substrats standards en silicium par exemple, s'accompagne généralement d'une certaine variabilité qui peut conduire à un décalage spectral des propriétés de filtrage de ces traitements. En effet, entre la périphérie et le centre d'un même substrat, ou entre plusieurs substrats, l'épaisseur déposée suivant les procédés usuels pour la fabrication de filtres multicouches peut varier significativement. Par conséquent les limites spectrales de filtrage du traitement optique, qui sont notamment contrôlées par l'épaisseur de chacune des couches interférentielles, peuvent être décalées en fonction de la position de la fenêtre sur le substrat, ou/et selon le substrat considéré.

Une fenêtre fabriquée collectivement selon l'invention aura préférentiellement une transition ou « *cut-on* », spectrale passe-haut contrôlée par le filtre diffractif. Notamment, la limite spectrale de filtrage du filtre diffractif est principalement contrôlée par le pas (ou période) du réseau. Or, les techniques typiquement utilisées pour fabriquer le réseau, de type photolithographie microélectronique, permettent le contrôle de ce pas de manière très précise par rapport au pas lui-même (1 à 5 $\mu$m, typiquement). La construction de la fenêtre selon l'invention offre ainsi un degré de contrôle et une maîtrise du seuil de transmission bien plus élevés que selon la technique usuelle des filtres interférentiels multicouches.

La meilleure maîtrise de la limite basse de la bande spectrale passante grâce à l'utilisation de filtre diffractif permet d'envisager des architectures de filtres interférentiels multicouches (cas du premier mode de réalisation) autorisant plus de latitude au niveau du contrôle des limites spectrales, et donc de latitude sur la précision des épaisseurs et du nombre de couches déposées. En effet, les bornes de la bande spectrale de la fenêtre sont fixées par le filtre diffractif et non plus par le filtre interférentiel. Par ce biais, les spécifications de l'unique filtre multicouche interférentiel sont relâchées par rapport à ce qu'exige la construction traditionnelle à deux filtres, d'où un gain potentiel de complexité, c'est-à-dire de coût de fabrication, de maîtrise de transmission spectrale dans le spectre d'intérêt, et de densité de défauts structuraux. Globalement, il en résulte une économie substantielle.

Selon un mode de réalisation, le réseau périodique est réalisé sur la face de la fenêtre la plus proche de la rétine, ou face interne.

Selon un mode de réalisation de l'invention, la période du réseau est comprise entre 1,1 et 1,4 fois la borne supérieure du deuxième intervalle, divisée par l'indice de réfraction optique du matériau constitutif du substrat de la fenêtre, et de préférence environ égal à 1,25 fois ladite borne.

Selon un mode de réalisation de l'invention, le réseau est réalisé dans l'épaisseur de la fenêtre et présente des motifs d'épaisseur comprise entre 1 micromètre et 2 micromètres.

Selon un mode de réalisation de l'invention, le réseau présente un facteur de remplissage compris entre 40% et 55%. Le facteur de remplissage est l'aire des reliefs du réseau par unité de surface.

Selon un mode de réalisation de l'invention, le filtre réalisé sur la première face de la fenêtre est un filtre multicouche interférentiel.

En variante, le filtre réalisé sur la première face de la fenêtre est un réseau de diffraction.

Selon un mode de réalisation de l'invention, la borne supérieure du deuxième intervalle est supérieure ou égale à la borne supérieure du premier intervalle. Plus particulièrement :

- le filtre réalisé sur la première face de la fenêtre est apte à atténuer le rayonnement incident au moins dans la gamme de longueurs d'onde comprises entre 2 et 5 micromètres ; et
- le réseau périodique est apte à atténuer le rayonnement incident au moins dans la gamme de longueurs d'onde comprises entre 5 et 8 micromètres.

Avantageusement, le filtre réalisé sur la première face de la fenêtre se comporte sur la gamme de longueurs d'onde comprises entre 2 et 14 micromètres sensiblement comme un filtre passe-haut. Plus particulièrement, le rapport de la longueur d'onde de coupure du filtre passe haut divisée par l'indice de réfraction optique du substrat constitutif de la fenêtre est compris entre 1 et 1,5 fois le pas du réseau périodique de motifs, voire sensiblement égal audit pas du réseau.

Selon un mode de réalisation de l'invention, le réseau périodique comporte des motifs agencés selon un pavage d'Archimède ou de Penrose.

Selon un mode de réalisation de l'invention, la fenêtre est réalisée dans un substrat minéral, notamment en silicium ou en germanium.

**BREVE DESCRIPTION DES FIGURES**

L'invention sera mieux comprise à la lecture de la description qui suit, donnée uniquement à titre d'exemple, et réalisée en relation avec les dessins annexés, dans lesquels :

- la figure 1 est une vue schématique en coupe d'un détecteur infrarouge selon l'invention ;
- la figure 2 est une vue schématique en coupe plus en détail d'une fenêtre selon l'invention entrant dans la constitution du détecteur de la figure 1 ;
- la figure 3 est un spectre de transmission d'un filtre multicouche interférentiel réalisé sur la face externe de la fenêtre du détecteur conforme à l'invention ;
- la figure 4 est un spectre de transmission d'un réseau de diffraction réalisé sur la face interne de la fenêtre du détecteur conforme à l'invention ;
- la figure 5 est un spectre de transmission de la fenêtre du détecteur combinant les filtre et réseau illustrés aux figures 3 et 4 respectivement ;
- la figure 6 est un pavage hexagonal utilisé pour définir un pavage d'Archimède ;
- la figure 7 est une vue illustrant les trois points de la maille du pavage d'Archimède à partir du pavage de la figure 6 ; et
- la figure 8 est une vue de dessus d'un réseau de diffraction comprenant des plots circulaires agencés selon un pavage d'Archimède.

DESCRIPTION DETAILLEE DE L'INVENTION

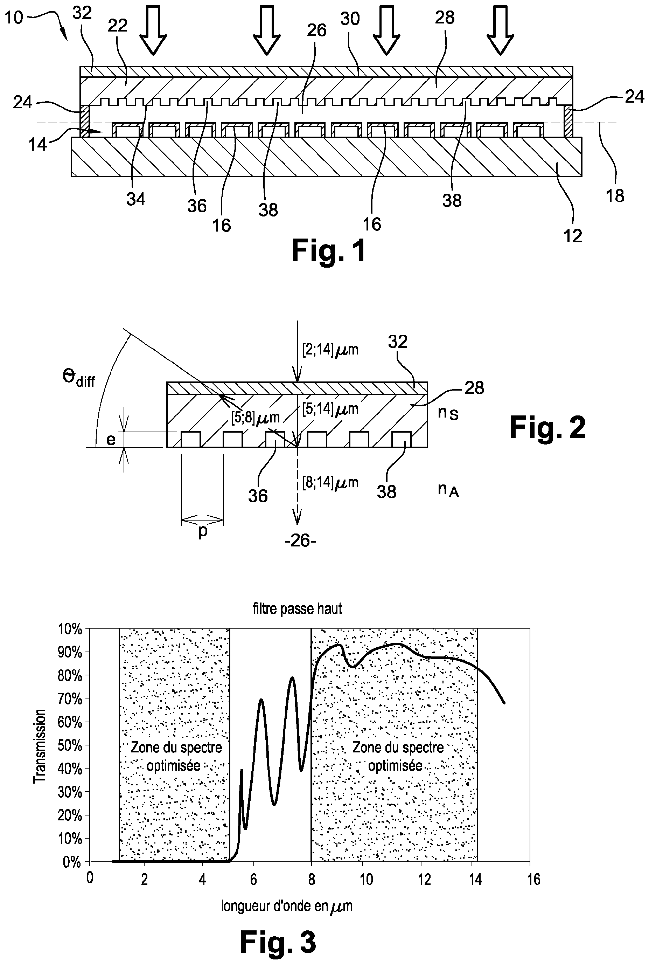

Sur la figure 1, un détecteur bolométrique infrarouge 10 comprend une embase 12 comportant en face supérieure un circuit de lecture, une rétine sensible 14, constituée d'une pluralité de membranes bolométriques 16 suspendues au dessus du circuit de lecture à l'aide de bras de soutien mécanique et d'isolation thermique. Les membranes 16 constituent chacune un point sensible du détecteur à un rayonnement infrarouge, en particulier de longueur d'onde comprise entre 8 $\mu$m et 14 $\mu$m. La rétine 14 est placée dans le plan focal 18 d'une optique (non représentée). Le circuit de lecture n'est pas différencié de l'embase 12 sur la figure 1, où il constitue en soi cette embase, mais peut aussi être rapporté sous la forme d'une puce électronique assemblée sur la surface interne d'un fond d'un boitier traditionnel, l'ensemble constituant l'embase 12 selon l'invention. Le circuit de lecture comprend par ailleurs des circuits d'adressage et de polarisation (également non représentés) nécessaires à la formation des signaux utiles à l'aide des membranes 16.

Le détecteur 10 comporte par ailleurs une première paroi 22, située en regard de la rétine 14 et placée sur le trajet optique entre cette dernière et l'optique, des parois latérales 24, et l'embase 12 munie de la rétine 14. L'ensemble formé des éléments 12, 22, 24 forme un boitier de protection mécanique pour la rétine 14 et définit un espace 26 habituellement hermétique, et dans lequel règne typiquement une pression de gaz réduite.

La paroi 22 située en regard de la rétine 14 comprend un substrat plan 28, au moins partiellement transparent entre 8 et 14 $\mu$m. La paroi ou fenêtre 22 est usuellement réalisée d'un seul tenant et en un seul matériau minéral, tel que du silicium ou du germanium typiquement, qui offre à la fois une bonne tenue mécanique et une capacité satisfaisante d'intégration hermétique aux parois 24, tout en permettant une texturation de sa surface à l'aide de techniques de photolithographie et de gravure.

Ces matériaux sont naturellement essentiellement transparents entre 8 et 14 $\mu$m, mais aussi depuis 2 $\mu$m et au moins jusqu'à 20 $\mu$m, de sorte qu'il est exclu d'obtenir le filtrage recherché en dessous de 8 $\mu$m au moyen de l'absorption propre du substrat 28.

La description proposée s'applique particulièrement aux détecteurs bolométriques, mais de manière non exclusive, l'invention s'applique également à tout type de détecteur opérant dans le domaine de longueurs d'ondes considéré. De même, les relations géométriques et physiques particulières qui définissent l'invention peuvent être appliquées à une région différente du spectre infrarouge, au moins tant que les principes en demeurent applicables de manière utile.

La face 30 externe du substrat 28, c'est-à-dire celle la plus éloignée de la rétine 14, est munie d'un filtre multicouche interférentiel 32, conçu pour atténuer la transmission optique globale de la fenêtre 22 sur une première gamme de longueurs d'onde comprise entre 2 $\mu$m et 8 $\mu$m, avantageusement sur la gamme de longueurs d'onde comprises entre 2 et 5 $\mu$m. La largeur limitée de cette gamme permet notamment de prévoir un filtre interférentiel présentant un nombre limité de couches, et corolairement un nombre et une taille de défauts limités par rapport à un filtre interférentiel conçu pour atténuer la transmission de la fenêtre sur l'intervalle complet de 2 à 8 $\mu$m.

Avantageusement, les propriétés optiques du substrat 28 de la fenêtre 22 sont également prises en compte pour concevoir le filtre 32. En effet, en choisissant un substrat 28 minéral, notamment en germanium ou en silicium, la fenêtre 22 est opaque pour toute longueur d'onde inférieure à une limite intrinsèque d'opacité de 2$\mu$m (dans le vide) pour le germanium et une limite de 1,2 $\mu$m pour le silicium. Aussi, un filtre 32 qui présente une transmission optique de type passe haut pour les longueurs d'onde supérieures à la limite d'opacité permet d'obtenir le filtrage souhaité, quand bien même la transmission de ce filtre serait élevée pour des longueurs d'onde inférieure à la limite d'opacité.

Les lentilles des optiques mises en œuvre avec ces détecteurs sont très généralement formées en germanium, de ce fait aucun rayonnement émis par la scène en dessous de 2 $\mu$m n'atteint la fenêtre du détecteur. Il n'est ainsi généralement pas besoin de filtrer au moyen de la fenêtre le rayonnement entre 1,2 et 2$\mu$m. C'est pourquoi on s'en tient dans cet exposé uniquement à des longueurs d'onde supérieures à 2 $\mu$m.

Un exemple de fonction de transmission optique entre un rayonnement transmis par le filtre 32 et un rayonnement incident sur celui-ci est par exemple représenté à la figure 3.

La face interne 34 de la fenêtre 22, c'est-à-dire la face la plus proche de la rétine 14, est quant à elle texturée de manière à présenter un réseau périodique 36 de motifs 28 formant un réseau de diffraction, par exemple un réseau de plots en relief. Le réseau de diffraction 36 est conçu pour atténuer la transmission optique globale de la fenêtre 22 sur une deuxième gamme de longueurs d'onde comprise entre 2 $\mu$m et 8 $\mu$m, avantageusement sur la gamme de longueurs d'onde comprises entre 5 et 8 $\mu$m. Plus particulièrement, comme illustré dans la vue de détail de la figure 2, les propriétés du réseau 36, à savoir notamment la géométrie de ses motifs, essentiellement leur taux de remplissage, et le pas $p$ du réseau sont choisis de manière à ce que les longueurs d'onde comprises dans la deuxième gamme soient déviées d'un angle de diffraction $\theta_{diff}$ tel que ces longueurs d'onde ne sont pas incidentes sur la rétine 14. L'énergie ainsi diffractée n'est plus transmise dans l'axe optique, mais déviée hors dudit axe optique selon des angles élevés dans le demi-espace incident, de sorte que le rayonnement n'atteint pas le plan focal à ces longueurs d'onde. Le résultat en termes de formation de l'image sur le plan focal est équivalent à une atténuation sévère de transmission pour cette gamme de longueurs d'onde.

Comme décrit précédemment, le réseau de diffraction est avantageusement réalisé à l'aide de techniques de photolithographie ou de gravure usuelles de l'état de la technique qui permettent à la fois une production à grande échelle et une reproductibilité élevée, de sorte que la taille et la densité de défauts du réseau de diffraction sont très limitées.

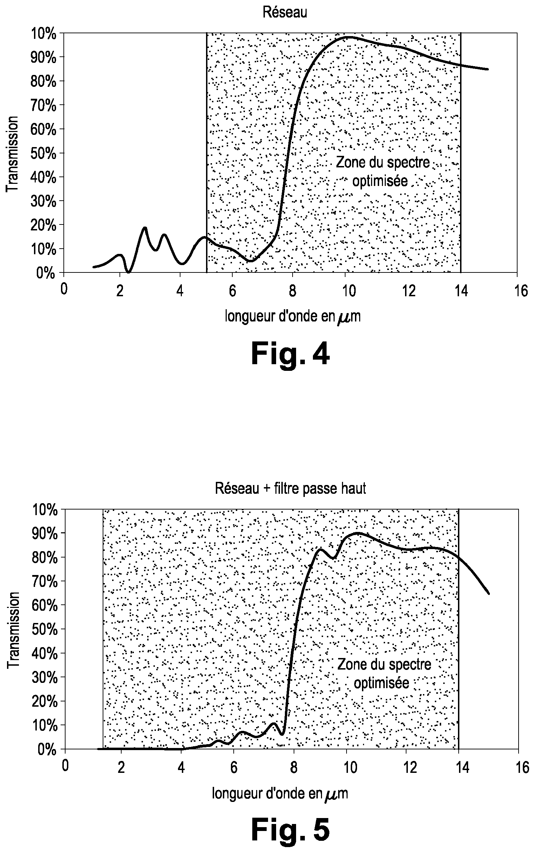

Un exemple de fonction de transmission optique entre un rayonnement transmis par le réseau de diffraction 36 et un rayonnement incident sur celui-ci est par exemple représenté à la figure 4.

La combinaison du spectre illustré à la figure 3 et du spectre illustré à la figure 4, c'est-à-dire la transmission optique globale de la fenêtre 22 entre un rayonnement transmis par celle-ci et un rayonnement incident sur celle-ci, est représenté à la figure 5.

De manière avantageuse, les propriétés optiques du réseau de diffraction 36 sont isotropes, afin de ne pas être sélectif vis-à-vis d'une polarisation particulière du rayonnement. En effet, le rayonnement collecté dans la plupart des applications de type imagerie infrarouge ne présente aucun caractère particulier de polarisation. A cet effet, le réseau 36 présente une symétrie élevée, notamment d'ordre 4 ou 6, c'est-à-dire carrée ou hexagonale, ou des ordres supérieurs. Bien entendu, d'autres dispositions sont possibles s'il est au contraire, par exemple, recherché une anisotropie de polarisation transmissive / diffractive.

L'ordre de symétrie de rotation du réseau permet dans une certaine mesure de régler la raideur du passage entre la gamme atténuée, en deçà de 8 $\mu$m, et la gamme transmise, au-delà de 8 $\mu$m. Cette raideur est représentée sur la figure 5 par la pente du spectre de transmission autour de 8 $\mu$m. En effet, l'intensité de chacun des ordres diffractés dépend de l'ordre de symétrie du réseau 36. Ainsi, un réseau hexagonal (de symétrie d'ordre 6) aura une pente différente d'un réseau de symétrie d'ordre 4. Il est constaté généralement qu'un ordre de symétrie plus élevé induit une transition plus raide au niveau de la « coupure », ou « cut-on », du réseau diffractif 36.

Un avantage dans le contexte de l'invention d'une symétrie élevée résulte également, comme l'on observé les inventeurs, du fait que l'atténuation de l'intensité du rayonnement transmis liée à la diffraction par le réseau, c'est-à-dire l'atténuation dans la deuxième partie du spectre filtré, augmente très sensiblement avec l'ordre de symétrie du réseau. Ainsi par exemple, un réseau hexagonal induit une atténuation moyenne de 80% sur la gamme 5-8 $\mu$m, alors que le réseau ayant un pavage d'Archimède permet une atténuation moyenne supérieure à 90%, voire 95%, sur cette même gamme.

Une symétrie avantageuse d'ordre élévé peut être obtenue si le réseau 36 comprend une maille du type « quasi-cristal ». Par exemple, le réseau 36 est un réseau de motifs à deux dimensions issu de pavages de Penrose, ces pavages présentant des motifs répétés périodiquement dont la symétrie est d'ordre 5 ou 10. De tels réseaux peuvent être construits par exemple selon la méthode décrite par : « Construction de pavages du plan par la méthode des multi-grilles », Denis Gratias, LEM-CNRS/ONERA, 2002.

En variante, le réseau 36 est un réseau de motifs dits d'Archimède, répétés périodiquement de manière à former des motifs plus grands dont la symétrie est d'ordre 12.

Notamment, un réseau de motifs issu d'un pavage d'Archimède permet d'obtenir une transition de faible largeur entre la gamme atténuée et la gamme transmise, à savoir une largeur d'environ 2 $\mu$m pour un coupure autour de 8 $\mu$m. A l'inverse, la coupure d'un réseau à maille carrée s'étendra sur une bande spectrale plus importante, typiquement une largeur d'environ 2,5 $\mu$m pour une coupure autour de 8 $\mu$m.

Un réseau issu de pavage d'Archimède adapté à l'invention peut être construit de la manière suivante.

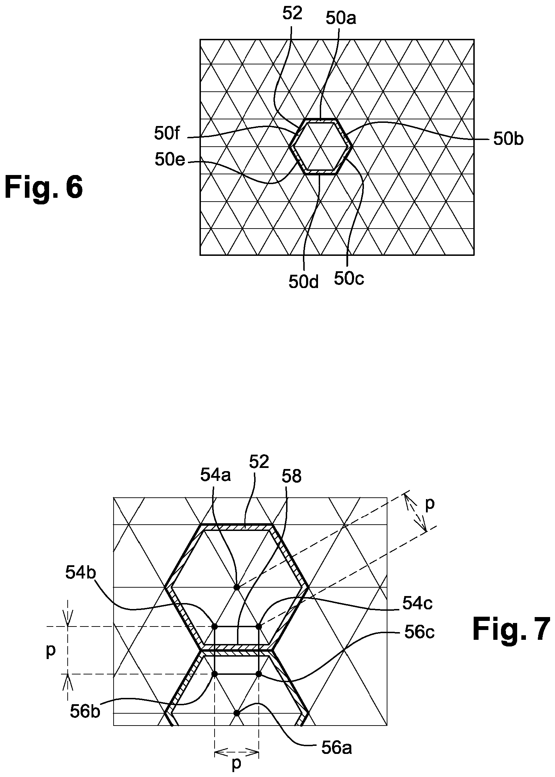

Tout d'abord, on réalise un assemblage de triangles équilatéraux **50a-50f** arrangés de façon à former un hexagone 52 (motif d'Archimède de base). Puis ce motif de base est répété de façon périodique afin de réaliser un premier pavage jointif, tel que représenté à la figure 6.

Trois points sont ensuite définis sur l'un des triangles équilatéraux **50a-50f** de chaque hexagone 52 et sont répétés par rotation autour du centre de rotation correspondant au centre de l'hexagone, sur chaque triangle de chaque hexagone. Par construction, le réseau de points obtenu présente au moins une symétrie d'ordre 6. Afin d'obtenir simultanément une symétrie d'ordre 4, les trois points précités sont placés de manière spécifique sur les triangles équilatéraux. Un premier point 54a est placé au centre du motif de base, et les deux autres points **54b** et **54c** sont respectivement placés sur les arêtes du triangle concourant au point 54a, de manière équidistante au centre 54a, et de manière à former un motif carré (symétrie d'ordre 4) avec des points correspondants **56b** et **56c** du motif de base voisin. La distance p des points **54b** et **54c** au point 54a est ainsi égale aux distances entre les points **54b** et **56b,** ainsi qu'entre les points **54c** et 56c.

Par construction et répétant le positionnement de ces trois points sur chaque triangle comme décrit précédemment, puis en pavant le plan avec les hexagones ainsi obtenus, les points forment un réseau de divers motifs périodiquement répétés présentant des symétries d'ordres 1, 2, 3, 4, 6 et 12. Par conséquent le nombre d'ordres diffractés est plus élevé que celui d'un maillage classique, à base de maille carrée ou hexagonale par exemple, dont la symétrie est limitée aux ordres 4 ou 6.

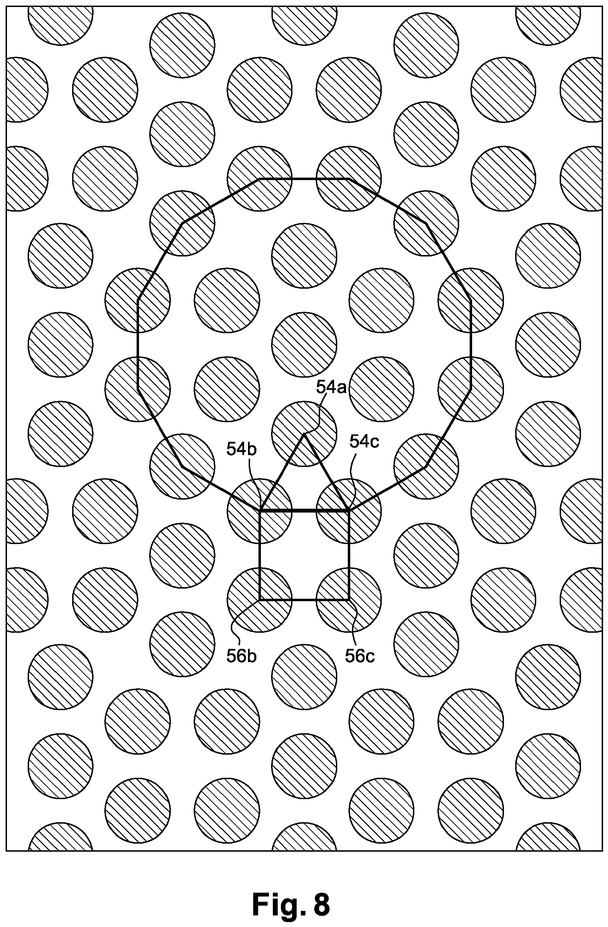

Des plots, par exemple circulaires, texturés à la surface 34 du substrat 28 de la fenêtre 22 et positionnés en chacun des points selon la construction venant d'être décrite, sont illustrés à la figure 8, sur laquelle les motifs de diverses symétries sont matérialisés.

La période d'un réseau issu de pavage d'Archimède est à comprendre dans la suite de l'exposé comme le paramètre p de la figure 7 qui correspond à la distance entre deux points de la construction, c'est-à-dire entre les centres de deux plots voisins.

Le pavage de Penrose permet de constituer un réseau à deux dimensions dont l'ordre de symétrie 5 ou 10 est globalement conservé.

Le réseau issu de pavage de Penrose peut être construit selon la méthode connue des multigrilles. La méthode des multigrilles permet d'obtenir un réseau à deux dimensions de symétrie d'ordre N (N = 5 pour le pavage de Penrose) :

> un ensemble de droites parallèles entre elles et régulièrement espacées est construit ;
> un centre de rotation est fixé sur l'une des droites ;
> le réseau de droites est reproduit par rotation autour du centre de symétrie selon l'angle suivant et qui permet d'obtenir une symétrie d'ordre N = 5 : 360° / 5 = 72°.

➢ le premier réseau de droites est ensuite répliqué par rotation une seconde fois selon le même centre de rotation avec un angle égale à (360° / 5) x 2 = 144°.
➢ le premier réseau de droites est alors répliqué selon le même principe pour les angles suivants : (360° / 5) x 3 et (360° / 5) x 4.
➢ par construction, les points d'intersection des droites correspondent alors aux nœuds d'un réseau de symétrie d'ordre 5.
➢ les plots du réseau utilisé pour l'invention sont alors placés sur chacun des nœuds afin d'obtenir un réseau de plots de symétrie d'ordre 5.

La plus courte distance entre les droites parallèles (selon la normale, donc) utilisée pour construire le réseau est assimilable à la période de ce réseau issu de pavage de Penrose.

Il va à présent être décrit plus en détail les caractéristiques du réseau de diffraction **36** permettant de régler la gamme d'atténuation.

Dans le cas d'un réseau **36** obtenu par texturation du substrat **28**, le premier ordre diffracté apparait sous incidence normale, pour la longueur d'onde :

$$\lambda = p \cdot (n_s + n_a) \quad (1)$$

où :

- $\lambda$ et la longueur d'onde dans le vide ;
- $p$ est la période du réseau **36** ;
- $n_s$ est l'indice de réfraction du substrat **28** ; et
- $n_a$ est l'indice de réfraction de l'espace **26,** par exemple de l'air ou du vide. Dans ce qui suit, il est posé $n_a$ = 1.

Afin d'obtenir un filtrage diffractif avantageux dans le cadre de l'invention, il convient de choisir une période suffisamment élevée pour que le réseau diffracte efficacement dans la bande spectrale à atténuer, à savoir pour des longueurs d'onde comprises entre 5 μm et 8 μm. Toutefois, la période du réseau ne doit pas être trop élevée afin de limiter la diffraction dans la bande spectrale dans laquelle la transmission doit être optimisée, à savoir pour des longueurs d'onde comprises entre 8 μm et 14 μm.

En pratique, un filtrage diffractif efficace est obtenu avec un réseau **36,** sans affecter de manière significative la transmission pour les longueurs d'onde plus élevées, lorsque la période p du réseau provoque l'apparition des premiers ordres diffractés à une longueur d'onde dans le substrat **28** comprise entre 1,1 et 1,4, et typiquement environ égale à 1,25 fois la longueur d'onde de coupure dans le substrat **28** souhaitée pour le réseau.

Pour atténuer au mieux le rayonnement de longueurs d'onde inférieures à 8 μm par exemple, la période p du réseau **36** est ainsi choisie de manière à ce que le premier ordre de diffraction apparaisse environ vers 10,5

μm dans le vide. Ainsi l'atténuation diffractive sur la bande spectrale de longueurs d'onde comprises entre 5 et 8 μm devient appréciable, et la transmission pour la bande spectrale de longueurs d'onde comprises entre 8 et 10 μm est peu affectée car l'intensité diffractée reste modérée sur cette bande spectrale.

Dans le mode de réalisation préféré de l'invention, dans lequel le réseau **36** est réalisé sur la face interne de la fenêtre **22**, le rayonnement se propage, lorsqu'il atteint le réseau **36**, du substrat **28** vers l'espace **26,** à savoir l'air ou le vide. Pour les longueurs d'onde dans l'espace **26,** vide, supérieures à la période p du réseau **36,** les différents ordres diffractés ne perturbent donc pas l'image formée sur la rétine **16,** car ces modes diffractés se propagent en réflexion et repartent donc dans le substrat **28** de la fenêtre **22**.

En effet, l'angle de diffraction d'un ordre de diffraction pour un réseau symétrique à deux dimensions suit la loi suivante :

$$n_s \cdot sin \; (\theta s_{i,j}) = (i+j) \cdot \lambda_s/p \qquad (2)$$

où

- $\lambda_s$ est la longueur d'onde dans le substrat **28,** c'est-à-dire $\lambda_s = \lambda/n_s$;
- $\theta s$ est l'angle de diffraction de l'ordre considéré dans le substrat ; et
- $i$ et $j$ correspondent aux indices de l'ordre considéré.

Les premiers ordres diffractés dans le substrat, dits ordres « 0 1 » ou « 1 0 », apparaissent donc selon l'angle:

$$\theta s \; = arcsin \; (\lambda_s \, / \, p) \qquad (3)$$

L'angle associé auquel apparait le premier ordre diffracté (« 0 1 » ou « 1 0 ») dans le demi-espace **26** est donné par la loi de Snell-Descartes : $sin \; \theta_v = n_s \cdot sin \; \theta s$ , et est égal à

$$\theta_v = arcsin \; (\lambda \, / \, p) \qquad (4)$$

La relation (4) indique que le premier ordre diffracté transmis apparait lorsque la longueur d'onde dans le vide est inférieure à la période du réseau. Pour les longueurs d'onde dans le vide supérieures à la période du réseau, les ordres diffractés n'apparaissent donc qu'en réflexion.

Dans le cadre de l'invention, on souhaite ne pas perturber l'image véhiculée par le front d'onde incident par des halos de diffraction inhérents aux ordres transmis par la face de la fenêtre 22 comprenant le réseau 36. Les longueurs d'onde dans le substrat constitutif de la fenêtre inférieures à la période p du réseau 36, qui seraient transmises avec une déviation variable selon leur longueur d'onde, et donc susceptibles d'atteindre le plan focal directement ou après diverses réflexions à l'intérieur du boîtier contenant ledit plan focal, sont donc avantageusement substantiellement atténuées par le filtre interférentiel 32 passe-haut disposé sur la face externe de la fenêtre 22. La longueur d'onde de coupure ou « *cut-on* » du filtre 32 dans le substrat constitutif de la fenêtre est choisie égale ou légèrement supérieure au pas p du réseau 36, notamment une longueur d'onde de coupure comprise entre 1 et 1,5 fois la période p du réseau 36. Dans ces conditions, les longueurs d'onde inférieures au « *cut-on* » n'atteignent pas le réseau, car elles sont réfléchies au niveau de l'interface air-substrat 28.

Le spectre de transmission du filtre interférentiel 32 adapté est illustré à la figure 3.

Plus précisément, la fenêtre selon l'invention permet d'effectuer un filtrage efficace grâce au mécanisme de diffraction réfléchie dans la gamme spectrale suivante :

$$p \le \lambda \le \frac{1}{1,25} \times n_s \times p,$$

c'est-à-dire :

$$p \le \lambda \le 0,8 \times n_s \times p \quad (6)$$

Le choix de la période $\underline{p}$ du réseau 36 et de l'indice $n_s$ du substrat 28 détermine donc les propriétés spectrales du filtre diffractif disposé sur la face interne de la fenêtre 32, notamment en termes de limites et de largeur de la bande spectrale atténuée.

Par exemple pour un substrat 28 réalisé en silicium, d'indice $n_s$ = 3,4, la période p est choisie sensiblement égale à $n_s \times \dfrac{\lambda}{0,8}$ . En choisissant la longueur d'onde $\lambda$ dans le vide égale à 8 $\mu$m, on a ainsi p = 2,9 $\mu$m.

D'une manière générale selon le compromis transmission / filtrage, la période p du réseau **36** est choisie entre 2 $\mu$m et 4 $\mu$m, notamment pour un substrat **28** en silicium. Dans la pratique un résultat très acceptable dans ce cas est obtenu avec un pas de réseau p entre 2,6 et 3,3 $\mu$m, c'est à dire en appliquant un rapport $\dfrac{n_s \times p}{\lambda}$ compris entre 1,1 et 1,4.

Contrairement à l'état de l'art concernant l'utilisation de réseau pour l'imagerie infrarouge, comme par exemple celle décrite au sein du document WO02/054499, la période utilisée n'est pas inférieure à toutes les longueurs d'onde dans le substrat constitutif de la fenêtre, de la gamme d'intérêt de longueurs d'onde dans le vide comprises entre 8 et 14 $\mu$m

Les autres paramètres géométriques du réseau **36,** notamment l'épaisseur e des motifs en relief et leur facteur de remplissage, c'est-à-dire l'aire des reliefs par unité de surface, sont déterminés par exemple grâce aux lois de la théorie dite « *effective medium theory* » et aux lois de l'optique matricielle, selon des techniques connues, de manière à optimiser la transmission dans la bande spectrale d'intérêt. Pour optimiser la transmission sur la gamme de l'infrarouge long 8 - 14 $\mu$m, il est notamment avantageux de dimensionner le réseau **36** comme une lame quart d'onde à 10 $\mu$m.

A cet effet, l'épaisseur e des motifs du réseau **36** satisfait la relation suivante :

$$e = \frac{\lambda_M}{4 \times n_{eff}} \qquad (7)$$

où :

- $n_{eff}$ est l'indice efficace préférentiellement égal à ou voisin de $\sqrt{n_s \times n_a}$ ; et
- $\lambda_M$ est la longueur d'onde dans le vide pour le maximum de transmission, soit $\lambda_M$ = 10 $\mu$m pour une lame quart d'onde réglée sur 10 $\mu$m.

Pour un substrat **28** en silicium, $n_s$ = 3,4 entre 8 $\mu$m et 14 $\mu$m, et en posant $n_a$ = 1, l'épaisseur e des motifs du réseau **36** est donc préférentiellement égale à 1,35 $\mu$m.

L'indice efficace $n_{eff}$ du réseau **36** selon l'« *effective medium theory* » est déterminé par le facteur de remplissage du réseau. Le facteur de remplissage nécessaire pour obtenir l'indice efficace voulu peut être évalué par des formules connues de l'état de la technique. On se référera par exemple au document "Antireflection surfaces in Silicon using binary optics technology", APPLIED OPTICS, Vol 31, No 2, 1st August, Motamedi et AI. Une approche empirique est cependant également possible pour obtenir une estimation pertinente.

Finalement, un réseau **36** réalisé dans l'épaisseur d'un substrat **28,** notamment en silicium, présente avantageusement les caractéristiques géométriques suivantes :

- une épaisseur des motifs, à savoir la profondeur de la texturation réalisée dans le substrat, comprise entre 1 et 2 $\mu$m ;
- un facteur de remplissage compris entre 40% et 55%.

D'autres géométries optimisant la transmission sur une gamme d'intérêt sont évidemment possibles, sans sortir du cadre de l'invention. Par exemple, des plots avec des murs non verticaux ou sur plusieurs niveaux de manière à réaliser une adaptation d'indice peuvent être utilisés à la place de la simple lame quart d'onde texturée en une seule fois selon de simples profils verticaux.

Il a été décrit un filtre multicouche interférentiel **32** en combinaison avec un réseau de diffraction **36**.

En variante, le filtre multicouche interférentiel passe-haut **32** est remplacé par un réseau diffractif de période inférieure au réseau diffractif **36**. Cette construction permet alors de se passer complètement des étapes de dépôts du filtre interférentiel **32** habituellement utilisées pour la fabrication de filtre dans le domaine de l'infrarouge. Seules des techniques de fabrication issues de la microélectronique sont utilisées dans ce cas, notamment des photolithographies et/ou des gravures pour la fabrication de la fenêtre **22**.

Le premier réseau diffractif **36** est donc complété par un second réseau diffractif, dont les caractéristiques, notamment la période, sont choisies de manière à former des premiers ordres diffractés réfléchis pour les longueurs d'onde qui seraient sans cette disposition diffractées transmises par le premier réseau **36**. On évite ainsi que l'image formée sur le plan focal ne soit altérée par la transmission de modes diffractés transmis.

Par exemple, pour une fenêtre **22** formée à partir d'un substrat **28** en silicium, destinée à ne transmettre que sur la gamme de longueurs d'onde comprises entre 8 et 14 $\mu$m, le premier filtre diffractif **36,** réalisé sur la face interne de la fenêtre **22,** est conçu selon les paramètres décrits dans le premier mode de réalisation afin de bloquer efficacement le rayonnement dans la gamme de longueurs d'onde dans le vide comprises entre 3 $\mu$m et 8 $\mu$m. Le second filtre diffractif, réalisé sur la face externe de la fenêtre **22,** a quant à lui typiquement une structure similaire au précédent, notamment en termes de périodicité du réseau et motif de répétition. En revanche, sa période de répétition, et donc son facteur d'échelle par rapport au premier réseau, est inférieure à la période du premier réseau, de l'ordre de 1 $\mu$m par exemple.

Ainsi, les ordres diffractés transmis au-delà de la première face de la fenêtre (supérieure, c'est-à-dire l'interface air-substrat **28)** apparaissent, pour un substrat **28** en silicium, en dessous d'environ 3,4 $\mu$m de longueur d'onde (dans le vide), compte tenu de l'indice du substrat **28**. Cependant, les rayons diffractés transmis de longueur d'onde (dans le vide) en dessous de 3,4 $\mu$m présentent un angle d'incidence sur la face inférieure du substrat **28** supérieur à l'angle de réflexion totale de Brewster et sont donc totalement réfléchis au niveau de la face inférieure (deuxième face de la fenêtre), et n'atteignent pas le plan focal. Par ailleurs, le substrat **28** en silicium bloque lui-même le rayonnement par absorption intrinsèque en dessous de 1,2 $\mu$m (dans le vide), de sorte que ce rayonnement n'est pas non plus transmis.

Dans le cas d'un substrat **28** en germanium, le seuil d'absorption intrinsèque est repoussé vers 2 $\mu$m, de sorte qu'un second réseau formé avec une période de l'ordre de 2 $\mu$m produit un effet équivalent de réflexion totale sur la deuxième face jusqu'à une longueur d'onde de l'ordre de 8 $\mu$m (dans le vide). On obtient alors une atténuation complémentaire à celle du premier réseau sur la partie haute du spectre à atténuer.

On obtient ainsi une fenêtre permettant de filtrer significativement tous les rayonnements inférieurs à 8 $\mu$m et d'optimiser la transmission pour les longueurs d'onde supérieures à 8 $\mu$m.

Le filtrage, sur l'ensemble de la bande spectrale normalement bloquée par les filtres interférentiels, est légèrement relâché par rapport à une fenêtre comportant deux filtres multicouches. Toutefois, l'ensemble des étapes de fabrication de ces fenêtres pouvant être réalisé par des techniques issues de la microélectronique, il est possible d'automatiser entièrement leur processus de production collective sur des substrats **28** de grande dimension avec une défectivité très faible. Ces substrats sont singularisés, typiquement par découpe mécanique, en fenêtres individuelles **22** après la fabrication des réseaux.

La mise en œuvre de l'invention procure un avantage particulier par rapport aux dispositions de filtrage spectral classiques, dans le cas où un élément de scène particulièrement chaud apparait dans le champ sensible du système optique. Par exemple, l'observation fortuite du soleil, dans des conditions d'ouverture optique ou/et de clarté atmosphérique élevées peut produire une dérive durable de la qualité des images, voire la destruction des éléments sensibles disposés au plan focal.

En effet, la majeure partie de l'énergie dissipée par de telles sources chaudes est distribuée aux longueurs d'ondes courtes, particulièrement en dessous de 8 $\mu$m. La diffraction exploitée dans le cadre de l'invention a pour effet, pour les longueurs d'onde au voisinage du seuil et en dessous, c'est-à-dire dans leur composante les plus énergétiques, d'étendre l'image sur le plan focal de ladite source au-delà de la surface nominale de l'image formée dans le spectre d'intérêt. Il en résulte la formation d'un halo interprétable comme une perte de résolution de l'image, mais en réalité peu préjudiciable pour l'utilisateur, car ces éléments de scène sont déjà non exploitables et dépourvus d'intérêt en observation infrarouge, car les éléments sensibles concernés produisent un signal saturé.

Par contre, la dispersion angulaire de l'énergie excessive locale, qui forme un halo de diffraction dans ce cas particulier de scène très contrastée, est d'autant plus étendue que la longueur d'onde est courte (énergétique), s'accompagne en conséquence d'un affaiblissement proportionnel de l'énergie reçue par les éléments sensibles concernés (la zone du plan focal formant l'image de la source chaude), car l'énergie incidente est répartie sur un plus grand nombre de points sensibles (pixels). Il en résulte que le risque de détérioration du détecteur par un éclairement trop intense est sensiblement diminué, voire éliminé.

La vulnérabilité des détecteurs constitués selon l'invention n'est donc typiquement pas plus élevée, voire meilleure par rapport à l'état de l'art habituel à base de filtres passe-haut sophistiqués et plus performants en termes de filtrage, mais nettement plus onéreux à fabriquer.

## Revendications

1. Détecteur infrarouge (10) comportant :

   ■ une rétine sensible (14) apte à détecter un rayonnement dans la gamme de longueurs d'onde comprises entre 8 et 14 micromètres ; et
   ■ un boitier (12, 22, 24) contenant la rétine sensible et comportant une fenêtre (22) située en regard de la rétine, ladite fenêtre comportant un substrat (28) au moins partiellement transparent dans la gamme de longueurs d'onde comprises entre 2 et 14 micromètres ; et
   ■ un ensemble de filtres optiques réalisé sur la fenêtre pour atténuer un rayonnement incident sur la rétine dans la gamme de longueurs d'onde comprises entre 2 et 8 micromètres,

   *caractérisé* **en ce que** l'ensemble de filtres est constitué :

   ■ d'un filtre optique (32) réalisé sur une première face (30) de la fenêtre et atténuant le rayonnement incident dans un premier intervalle de la gamme de longueurs d'onde comprises entre 2 et 8 micromètres, et transmettant le rayonnement dans la gamme de longueurs d'onde comprise entre 8 et 14 micromètres ; ledit filtre optique présentant un premier intervalle d'atténuation limité, c'est-à-dire un premier intervalle d'atténuation dont la largeur est inférieure à l'intervalle complet de 2 à 8 micromètres, et
   ■ d'un réseau périodique de diffraction (36), réalisé sur une deuxième face (34) de la fenêtre et atténuant en réalisant une réflexion par diffraction du rayonnement incident dans un deuxième intervalle de la gamme de longueurs d'onde comprises entre 2 et 8 micromètres différent du premier intervalle, et transmettant le rayonnement dans la gamme de longueurs d'onde comprise entre 8 et 14 micromètres .

2. Détecteur infrarouge selon la revendication 1, *caractérisé* **en ce que** le réseau périodique est réalisé sur la face de la fenêtre la plus proche de la rétine.

3. Détecteur infrarouge selon la revendication 1, *caractérisé* **en ce que** la période du réseau est comprise entre 1,1 et 1,4 fois la borne supérieure du deuxième intervalle divisée par l'indice de réfraction optique du substrat de la fenêtre, et de préférence environ égal à 1,25 fois ladite borne.

4. Détecteur bolométrique selon la revendication 1, 2 ou 3, *caractérisé* en ce le réseau est réalisé dans l'épaisseur de la fenêtre et présente des motifs, et en ce que le taux de remplissage du réseau périodique de diffraction et l'épaisseur des motifs du réseau périodique sont choisis de manière à réaliser à lame quart d'onde pour une longueur d'onde dans la gamme de longueurs d'onde comprise entre 8 et 14 micromètres.

5. Détecteur selon la revendication 4, *caractérisé* **en ce que** la longueur d'onde est égale à 10 micromètres.

6. Détecteur infrarouge selon l'une quelconque des revendications précédentes, *caractérisé* **en ce que** le réseau est réalisé dans l'épaisseur de la fenêtre et présente des motifs d'épaisseur comprise entre 1 micromètre et 2 micromètres.

7. Détecteur infrarouge selon l'une quelconque des revendications précédentes, *caractérisé* **en ce que** le réseau présente un facteur de remplissage compris entre 40% et 55%.

8. Détecteur infrarouge selon l'une quelconque des revendications précédentes, *caractérisé* **en ce que** le filtre réalisé sur la première face de la fenêtre est un filtre multicouche interférentiel.

9. Détecteur infrarouge selon l'une selon l'une quelconque des revendications 1 à 7, *caractérisé* **en ce que** le filtre réalisé sur la première face de la fenêtre est un réseau de diffraction.

10. Détecteur infrarouge selon l'une quelconque des revendications précédentes, *caractérisé* :

    ■ en ce que le filtre réalisé sur la première face de la fenêtre est apte à atténuer le rayonnement incident au moins dans la gamme de longueurs d'onde comprises entre 2 et 5 micromètres ; et
    ■ en ce que le réseau périodique est apte à atténuer le rayonnement incident au moins dans la gamme de longueurs d'onde comprises entre 5 et 8 micromètres.

11. Détecteur infrarouge selon l'une quelconque des revendications précédentes, *caractérisé* **en ce que** le filtre réalisé sur la première face de la fenêtre se comporte sensiblement comme un filtre passe-haut sur la gamme de longueurs d'onde comprises entre 2 et 14 micromètres.

12. Détecteur infrarouge selon la revendication 11, *caractérisé* **en ce que** le rapport de la longueur d'onde de coupure du filtre passe haut, divisée par l'indice optique du substrat de la fenêtre, est compris entre 1 et 1,5 fois la valeur du pas du réseau périodique de motifs, et de préférence est sensiblement égal audit pas du réseau.

13. Détecteur infrarouge selon l'une quelconque des revendications précédentes, *caractérisé* en ce que le réseau périodique comporte des motifs agencés selon un pavage d'Archimède ou de Penrose.

14. Détecteur infrarouge selon l'une quelconque des revendications précédentes, *caractérisé* en ce que la fenêtre est réalisée dans un substrat minéral, notamment en silicium ou en germanium.

15. Détecteur infrarouge selon l'une quelconque des revendications précédentes, *caractérisé* en ce que la fenêtre est obtenue par découpe d'un substrat sur lequel sont fabriqués collectivement une pluralité de réseaux sur au moins une face dudit substrat.

16. Détecteur infrarouge selon l'une quelconque des revendications précédentes, *caractérisé* en ce que la rétine est un assemblage bidimensionnel de membranes bolométriques.

17. Détecteur infrarouge selon l'une quelconque des revendications précédentes, *caractérisé* en ce que le réseau périodique de diffraction comprend des motifs en relief formés dans l'épaisseur de la fenêtre, et **en ce que** le facteur de remplissage du réseau périodique de diffraction et l'épaisseur des reliefs sont choisis de manière à ce que ledit réseau forme une lame quart d'onde pour une longueur d'onde égale à 10 micromètres.

**Patentansprüche**

1. Infrarotdetektor (10), der enthält:

- eine sensible Retina (14),

die in der Lage ist, eine Strahlung im Bereich der Wellenlängen zwischen 8 und 14 Mikrometern zu erkennen; und

- ein Gehäuse (12, 22, 24), das die sensible Retina enthält und ein Fenster (22) umfasst, das gegenüber der Retina, angeordnet ist, dieses Fenster enthält ein zumindest teilweise im Wellenlängenbereich zwischen 2 und 14 Mikrometern transparentes Substrat (28); und
- eine Einheit optischer Filter, ausgeführt auf dem Fenster zur Abschwächung einer auf die Retina einfallenden Strahlung im Wellenlängenbereich zwischen 2 und 8 Mikrometern,

*dadurch gekennzeichnet, dass* die Filtereinheit besteht aus:

- einem optischen Filter (32), ausgeführt auf einer ersten Seite (30) des Fensters, der die einfallende Strahlung in einem ersten Intervall des Wellenlängenbereichs zwischen 2 und 8 Mikrometern abschwächt und die Strahlung im Wellenlängenbereich zwischen 8 und 14 Mikrometern überträgt; dieser optische Filter weist ein erstes, begrenztes Abschwächungsintervall auf, das heißt ein erstes Abschwächungsintervall mit einer geringeren Breite, als das vollständige Intervall von 2 bis 8 Mikrometern, und
- ein periodisches Beugungsgitter (36), ausgeführt auf einer zweiten Seite (34) des Fensters, und das abschwächen wirkt, indem eine Beugungsreflexion der einfallenden Strahlung in einem zweiten Intervall aus dem Wellenlängenbereich zwischen 2 und 8 Mikrometern durchgeführt wird, die sich vom ersten Intervall unterscheidet, und die die Strahlung im Wellenlängenbereich zwischen 8 und 14 Mikrometern überträgt.

2. Infrarotdetektor nach Anspruch 1, *dadurch gekennzeichnet, dass* das periodische Gitter auf der Seite des Fensters ausgeführt wird, die der Retina am nächsten liegt.

3. Infrarotdetektor nach Anspruch 1, *dadurch gekennzeichnet, dass* die Periode des Gitters zwischen dem 1,1- und 1,4-fachen der oberen Klemme des zweiten Intervalls, geteilt durch den optischen Brechungsindex des Fenstersubstrats und vorzugsweise ungefähr gleich dem 1,25-fachen dieser Klemme liegt.

4. Bolometrischer Detektor nach Anspruch 1, 2 oder 3, *dadurch gekennzeichnet, dass* dieses Gitter in der Dicke des Fensters ausgeführt ist und Muster aufweist und dadurch, dass der Füllindex des periodischen Beugungsgitters und die Dicke der Muster des periodischen Gitters so ausgewählt werden, dass eine Lambda-Viertel-Verzögerung für eine Wellenlänge im Wellenlängenbereich zwischen 8 und 14 Mikrometern realisiert wird.

5. Detektor nach Anspruch 4, *dadurch gekennzeichnet, dass* die Wellenlänge gleich 10 Mikrometern ist.

6. Infrarotdetektor nach irgendeinem der vorangehenden Ansprüche, *dadurch gekennzeichnet, dass* das Gitter in der Dicke des Fensters und realisiert wird und Muster mit einer Dicke zwischen 1 Mikrometer und 2 Mikrometern enthält.

7. Infrarotdetektor nach irgendeinem der vorangehenden Ansprüche, *dadurch gekennzeichnet, dass*

das Gitter einen Füllfaktor zwischen 40% und 55% aufweist.

**8.** Infrarotdetektor nach irgendeinem der vorangehenden Ansprüche *dadurch gekennzeichnet, dass* dieser auf der ersten Seite des Fensters realisierte Filter ein mehrschichtiger Interferenzfilter ist.

**9.** Infrarotdetektor nach irgendeinem der vorangehenden Ansprüche 1 bis 7, *dadurch gekennzeichnet, dass* dieser auf der ersten Seite des Fensters realisierte Filter ein Beugungsgitter ist.

**10.** Infrarotdetektor nach irgendeinem der vorangehenden Ansprüche, *dadurch gekennzeichnet, dass:*

    ■ dieser auf der ersten Seite des Fensters realisierte Filter in der Lage ist, die einfallende Strahlung zumindest im Wellenlängenbereich zwischen 2 und 5 Mikrometern abzuschwächen; und
    ■ dadurch, dass das periodische Gitter in der Lage ist, die einfallende Strahlung zumindest im Wellenlängenbereich zwischen 2 und 5 Mikrometern abzuschwächen.

**11.** Infrarotdetektor nach irgendeinem der vorangehenden Ansprüche, *dadurch gekennzeichnet, dass* dieser auf der ersten Seite des Fensters realisierte Filter sich im Wesentlichen wie ein Hochpassfilter für den Wellenlängenbereich zwischen 2 und 14 Mikrometern verhält.

**12.** Infrarotdetektor nach Anspruch 11, *dadurch gekennzeichnet, dass* das Verhältnis der Grenzwellenlänge des Hochpassfilters, geteilt durch den optischen Index des Fenstersubstrats zwischen dem 1- und 1,5- fachen des Wertes der Teilung des periodischen Gitters der Muster liegt, und vorzugsweise im Wesentlichen gleich dieser Gitterteilung ist.

**13.** Infrarotdetektor nach irgendeinem der vorangehenden Ansprüche, *dadurch gekennzeichnet, dass* das periodische Gitter Muster enthält, die nach einem archimedischen oder Penrose- Prinzip angeordnet sind.

**14.** Infrarotdetektor nach irgendeinem der vorangehenden Ansprüche, *dadurch gekennzeichnet, dass* das Fenster aus einem mineralischen Substrat hergestellt wird, insbesondere aus Silizium oder aus Germanium.

**15.** Infrarotdetektor nach irgendeinem der vorangehenden Ansprüche, *dadurch gekennzeichnet, dass* das Fenster durch Schneiden eines Substrats entsteht, auf dem kollektiv eine Vielzahl von Gittern auf mindestens einer Seite dieses Substrats entsteht.

**16.** Infrarotdetektor nach irgendeinem der vorangehenden Ansprüche, *dadurch gekennzeichnet, dass* es sich bei der Retina um eine zweidimensionale Kombination bolometrischer Membrane handelt.

**17.** Infrarotdetektor nach irgendeinem der vorangehenden Ansprüche, *dadurch gekennzeichnet, dass* das periodisches Beugungsgitter Reliefmuster enthält, die in der Dicke des Fensters ausgebildet sind und dass der Füllfaktor des periodischen Beugungsgitters und die Dicke der Reliefs so ausgewählt werden, dass dieses Gitter ein Lambda-Viertel- Wellenplättchen für eine Wellenlänge gleich 10 Mikrometer bildet.

**Claims**

**1.** An infrared detector (10) comprising:

    ■ a sensitive retina (14) capable of detecting a radiation in the wavelength range between 8 and 14 micrometers; and
    ■ a package (12, 22, 24) containing the sensitive retina and comprising a window (22) located opposite to the retina, said window comprising a substrate (28) at least partially transparent in the wavelength range between 2 and 14 micrometers; and
    ■ a set of optical filters formed on the window to attenuate an incident radiation on the retina in a wavelength range between 2 and 8 micrometers,

**characterized in that** the set of filters is formed of:

    ■ an optical filter (32) formed on a first surface (30) of the window and attenuating the incident radiation in a first interval of the wavelength range between 2 and 8 micrometers, and transmitting the radiation in the wavelength between 8 and 14 $\mu$m; said optical filter presenting a first limited interval of attenuation, i.e. a first interval of attenuation which width is inferior to the whole interval of range between 2 $\mu$m and 8 $\mu$m, and
    ■ a periodic diffraction grating (36) formed on a second surface (34) of the window and attenuating by diffractive reflection the incident radiation in the wavelength range between 2 and 8 micrometers, different from the first interval, and transmitting the radiation in the wavelength range between 8 and 14 $\mu$m.

**2.** The infrared detector of claim 1, **characterized in that** the periodic grating is formed on the surface of the window closest to the retina.

**3.** The infrared detector of claim 1, **characterized in**

**that** the grating period ranges between 1.1 and 1.4 times the upper limit of the second interval, divided by the optical refraction index of the window substrate, and preferably approximately equal to 1.25 times said limit.

4. The infrared detector of claim 1, 2, or 3, **characterized in that** the grating is formed across the thickness of the window and has patterns, **in that** the filling factor of the periodic diffraction grating and the thickness of the raised patterns are selected to form a quarter-wave plate for a wavelength ranging between 8 $\mu$m and 14 $\mu$m.

5. The infrared detector of claim 4 **characterized in that** the wavelength is equal to 10 micrometers.

6. The infrared detector of any of the foregoing claims, **characterized in that** the grating is formed across the thickness of the window and has patterns of a thickness ranging between 1 micrometer and 2 micrometers.

7. The infrared detector of any of the foregoing claims, **characterized in that** the grating has a filling factor ranging between 40% and 55%.

8. The infrared detector of any of the foregoing claims, **characterized in that** the filter formed on the first surface of the window is a multilayer interference filter.

9. The infrared detector of any of claims 1 to 7, **characterized in that** the filter formed on the first surface of the window is a diffraction grating.

10. The infrared detector of any of the foregoing claims, **characterized in that**:

   ▪ the filter formed on the first surface of the window is capable of attenuating the incident radiation at least in the wavelength range between 2 and 5 micrometers; and
   ▪ the periodic grating is capable of attenuating the incident radiation at least in the wavelength range between 5 and 8 micrometers.

11. The infrared detector of any of the foregoing claims, **characterized in that** the filter formed on the first surface of the window substantially behaves like a high-pass filter over the wavelength range between 2 and 14 micrometers.

12. The infrared detector of claim 11, **characterized in that** the ratio of the cut-on wavelength of the high-pass filter to the optical index of the window substrate ranges between 1 and 1.5 times the value of the pitch of the periodical pattern grating, and is preferably substantially equal to said pitch of the grating.

13. The infrared detector of any of the foregoing claims, **characterized in that** the periodic grating comprises patterns arranged according to an archimedean or Penrose tiling.

14. The infrared detector of any of the foregoing claims, **characterized in that** the window is made of a mineral substrate, especially silicon or germanium.

15. The infrared detector of any of the foregoing claims, **characterized in that** the window is obtained by sawing of a substrate on which are collectively formed a plurality of gratings on at least one surface of said substrate.

16. The infrared detector of any of the foregoing claims, **characterized in that** the retina is a two-dimensional assembly of bolometric membranes.

17. The infrared detector of any of the foregoing claims, **characterized in that** the periodic diffraction grating has raised patterns formed across the thickness of the window, **in that** the filling factor of the periodic diffraction grating and the thickness of the raised patterns are selected so that the grating forms a quarter-wave plate for a wavelength equal to 10 micrometers.

**Fig. 1**

**Fig. 2**

filtre passe haut

**Fig. 3**

Réseau

## Fig. 4

Réseau + filtre passe haut

## Fig. 5

Fig. 6

Fig. 7

**Fig. 8**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 02054499 A

- US 2009080075 A

**Littérature non-brevet citée dans la description**

- **DENIS GRATIAS.** Construction de pavages du plan par la méthode des multi-grilles. *LEM-CNRS/ON-ERA,* 2002

- **MOTAMEDI.** Antireflection surfaces in Silicon using binary optics technology. *APPLIED OPTICS,* vol. 31 (2